# EUROPÄISCHE PATENTSCHRIFT

(11) **EP 0 371 317 B1**
(45) Veröffentlichungstag und Bekanntmachung des Hinweises auf die Patenterteilung: **08.06.1994**
(21) Anmeldenummer: 89121106.2
(22) Anmeldetag: 15.11.1989
(51) Int. Cl.: G08B 21/00

(54) **Lichtschranken-Sicherheitseinrichtung**
Light barrier safety device
Dispositif de sécurité à barrière lumineuse

(30) Priorität: 01.12.1988 DE 3840493
(43) Veröffentlichungstag der Anmeldung: 06.06.1990
(73) Patentinhaber: WERAC ELEKTRONIK GMBH, D-76744 Wörth (DE)
(72) Erfinder: Lexe, Werner, D-6729 Wörth 1 (DE)
(74) Vertreter: Pfeifer, Hans-Peter, Dr., Dr. H.-P. Pfeifer Dr. P. Jany, Patentanwälte

(56) Entgegenhaltungen:
- WO-A-81/00750
- WO-A-87/04259

## Beschreibung

Die Erfindung betrifft eine Lichtschranken-Sicherheitseinrichtung mit mehreren Lichtschranken, die jeweils einen Lichtsender und einen Lichtempfänger aufweisen, und mit einer Zentraleinheit, an der die Signale der Lichtschranken anliegen. Die Zentraleinheit fragt die Empfängersignale ab und erzeugt ein Sicherheitssignal, wenn mindestens eine Lichtschranke unterbrochen wird.

Lichtschranken-Sicherheitseinrichtungen werden vor allem im Maschinenbau vielfach eingesetzt. Die Lichtschranken können an verschiedenen Stellen der Maschine angeordnet sein. Vielfach werden sie auch zu sogenannten Lichtvorhängen zusammengefaßt, die aus vielen übereinander angeordneten Lichtstrahlen bestehen. Eine solche Lichtschranken-Sicherheitseinrichtung ist in der DE 37 90 010 T 1 beschrieben, wobei ein Mikroprozessor-Schrittschaltwerk zur Fortschaltung der Lichtschranken eines Lichtvorhanges eingesetzt wird.

Das Sicherheitssignal dient meist zur Betätigung eines Schütz, welcher die Maschine stillsetzt. Es können aber auch andere Sicherheitsfunktionen damit angesteuert werden, beispielsweise ein akustisches Warnsignal, eine automatische Absperrung des gefährlichen Bereiches oder dergleichen.

Aufgrund der existierenden Unfallverhütungsvorschriften wird ein außerordentlich hoher Sicherheitsstandard für die Funktion von Sicherheitslichtschranken verlangt. Für die Bundesrepublik Deutschland sind diese Anforderungen in der Vorschrift ZH 1/597 des Hauptverbandes der gewerblichen Berufsgenossenschaften zusammengefaßt. Aufgrund dieser steigenden Anforderungen werden neuerdings Mikrocomputer in der Zentraleinheit zur Abfrage der Empfängersignale und zur Erzeugung des Sicherheitssignals verwendet. Dies bedingt allerdings einen erheblichen Aufwand mit entsprechenden Kosten.
Fehler in dem Mikrocomputer selbst können dabei nur dadurch eliminiert werden, daß mindestens ein zweiter Mikrocomputer eingesetzt wird, wobei sich die beiden Mikrocomputer gegenseitig überprüfen.

Ziel der vorliegenden Erfindung war es, eine Lichtschranken-Sicherheitseinrichtung mit hohem Sicherheitsstandard bei möglichst geringem baulichen Aufwand zur Verfügung zu stellen.

Diese Aufgabe wird bei einer Einrichtung der eingangs bezeichneten Art mit Hilfe einer Zentraleinheit gelöst, die ein ROM-Schrittschaltwerk aufweist. Das ROM-Schrittschaltwerk enthält ein ROM und einen dem ROM nachgeordneten Schrittspeicher mit mindestens N bistabilen Speicherstellen sowie einen Taktgenerator zur Taktung des Schrittspeichers. Mindestens ein Teil N der Ausgänge des ROM, der als Rückführungsausgänge bezeichnet wird, liegt an N Rückführungseingängen des Schrittspeichers an. Die entsprechenden N Rückführungsausgänge des Schrittspeichers sind auf N Rückführungseingänge des ROM zurückgeführt. Dadurch bildet das jeweils an den Rückführungsausgängen des Schrittspeichers anliegende N-Bit-Wort einen Teil der am Eingang des ROM anliegenden Adresse, also eine erste Teiladresse des ROM. Das jeweils an den Rückführungsausgängen des ROM anliegende N-Bit-Wort bildet nach Taktung des Schrittspeichers die nächstfolgende erste Teiladresse. Infolgedessen läuft in dem ROM-Schrittschaltwerk eine durch den Speicherinhalt des ROM vorbestimmte Schrittfolge ab, solange der Schrittspeicher Taktsignale von dem Taktgenerator erhält. Mindestens ein Teil M der Ausgänge des Schrittspeichers dient als Ansteuerungsausgänge zur Ansteuerung der Lichtsender. Die Ausgangssignale der Empfänger liegen an weiteren Eingängen des ROM an, die als Empfängereingänge bezeichnet werden und bilden somit eine zweite Teiladresse des ROM. Die Gesamtadresse, die aus erster und zweiter Teiladresse gebildet wird, adressiert Speicherstellen des ROM, für die folgende Bedingungen gelten:
a) Für den Normalbetriebsfall, bei dem die zweite Teiladresse einer funktionierenden ununterbrochenen Lichtschranke entspricht, enthalten sie eine vorbestimmte Folge von Bit-Muster, bei der sich die an den Rückführungsausgängen anliegenden N-Bit-Worte zyklisch wiederholen, so daß sich die Schrittfolge des ROM-Schrittschaltwerks ebenfalls zyklisch wiederholt und die Lichtschranken über die Ansteuerungsausgänge zyklisch angesteuert werden.
b) Für den Störfall, bei dem die zweite Teiladresse nicht einer ununterbrochenen Lichtschranke entspricht, weicht der Speicherinhalt von der vorbestimmten Folge von Bit-Mustern ab.

Mindestens einer der Ausgänge des Schrittspeichers dient als Nutssignalausgang und ist mit einer Sicherheitssignalerzeugungseinrichtung verbunden. Diese erzeugt aufgrund des im Störfall abweichenden Speicherinhaltes das Sicherheitssignal.

Die Erfindung wird im folgenden anhand von in den Figuren schematisch dargestellten Ausführungsbeispielen näher erläutert, wobei auch auf bevorzugte Ausführungsformen und die mit der Erfindung im allgemeinen und den besonderen Ausführungsformen verbundenen Vorteile im Zusammenhang mit der Beschreibung der Figuren eingegangen wird. Es zeigen:
- Fig. 1: Ein Blockschaltbild einer ersten Ausführungsform der Erfindung,
- Fig. 2: eine Schrittfolgetabelle zur Erläuterung der Funktion der Ausführungsform nach Fig. 1,
- Fig. 3: ein Blockschaltbild einer verbesserten Ausführungsform der Erfindung,
- Fig. 4: eine Schrittfolgetabelle zur Erläuterung der Ausführungsform nach Fig. 3.

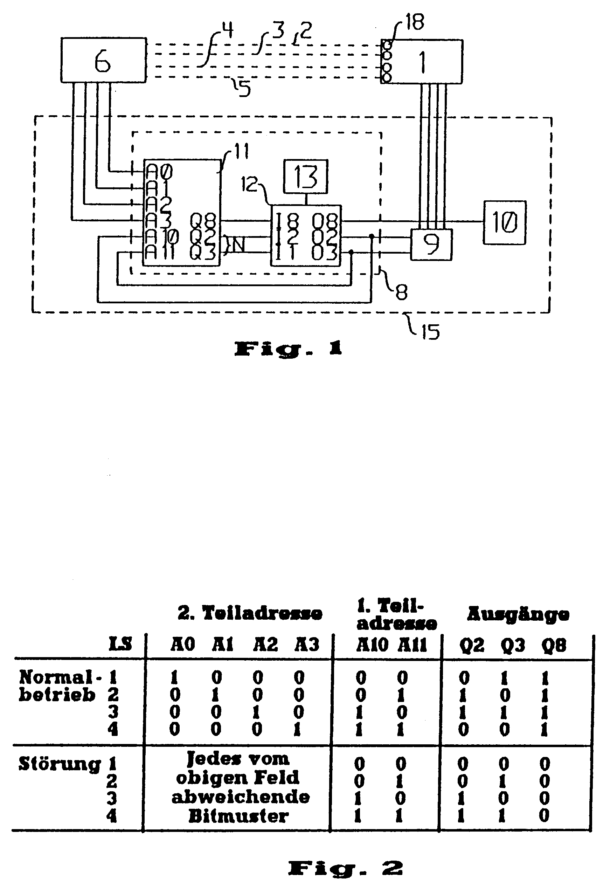

Figur 1 zeigt eine einfache Ausführungsform der Erfindung. Sie eignet sich insbesondere zur Erläuterung des erfindungsgemäßen Prinzips.

Eine Sendeeinheit 1 sendet vier Lichtstrahlen 2-5 an eine Empfängereinheit 6. Zu diesem Zweck enthält die Sendeeinheit vier im einzelnen nicht dargestellte Lichtsender und die Empfängereinheit vier Empfänger mit zugehöriger elektronischer Schaltung. Die vier Lichtschranken 2-5 bilden einen Lichtvorhang. Insoweit ist die Sicherheitseinrichtung konventionell ausgebildet. Selbstverständlich können die Sendeeinheit 1, die Empfängereinheit 6 und die Zentraleinheit 15 in unterschiedlicher Weise angeordnet werden. Bei einem Lichtvorhang mit Reflexionsprinzip können beispielsweise alle Teile kompakt in einem Gehäuse untergebracht sein.

Zur Ansteuerung der Lichtsender, zur Abfrage der Empfänger und zur Erzeugung eines Sicherheitssignals für den Fall, daß mindestens eine der Lichtschranken unterbrochen wird, dienen ein insgesamt mit 8 bezeichnetes ROM-Schrittschaltwerk, ein Decoder 9 und eine Sicherheitssignalerzeugungseinrichtung 10. Das ROM-Schrittschaltwerk umfaßt ein ROM 11, einen gemäß seiner Funktion als Schrittspeicher bezeichneten Speicherbaustein 12 mit mehreren bistabilen Speicherelementen und einen Taktgenerator 13. Insgesamt bilden die Elemente 8-13 die Zentraleinheit 15.

Das ROM 11 enthält eine Vielzahl von Speicherplätzen, die über die Adressierungseingänge angesteuert werden. Der Speicherinhalt des jeweils angesteuerten Speicherplatzes liegt an den Ausgängen Q an. Für die Erfindung genügt grundsätzlich ein ROM, da eine Änderung des Speicherinhaltes nach der Herstellung des Gerätes nicht mehr erforderlich ist. In der Praxis wird dennoch vorzugsweise ein PROM bzw. ein EPROM verwendet, da derartige Bausteine kostengünstig erhältlich sind und es bei verhältnismäßig kleinen Stückzahlen insgesamt weniger aufwendig ist, diese Bausteine jeweils bei der Herstellung der Lichtschranken-Sicherheitseinrichtung zu programmieren, statt ein spezielles ROM herzustellen.

Ein Teil N der Ausgänge des ROM, nämlich die Rückführungsausgänge Q2,Q3 ist mit entsprechenden Eingängen I2,I3 des Schrittspeichers 12 verbunden. Die entsprechenden Rückführungsausgänge O2,O3 des Schrittspeichers 12 sind auf Rückführungseingänge A10,A11 des ROM zurückgeführt.

Die Rückführungsausgänge O2,O3 des Schrittspeichers 12 sind zugleich mit dem Decoder 9 verbunden, welcher aus dem an seinen Eingängen anliegenden Bit-Muster Ansteuerungssignale für die Sendeeinheit 1 erzeugt. Dabei enspricht jedem Sender der Sendeeinheit 1 ein bestimmtes Bit-Muster an den Eingängen des Decoders. In der dargestellten bevorzugten Ausführungsform werden die an den Rückführungsausgängen O2,O3 des Schrittspeichers 12 anliegenden Signale zugleich zur Ansteuerung des Decoders verwendet. Dies ist jedoch nicht notwendigerweise der Fall. Es können auch spezielle Ausgänge des ROM und des Schrittspeichers 12 zur Ansteuerung des Decoders vorgesehen sein.

Das ROM weist weiterhin einen Nutzsignalausgang Q8 auf, der mit einem entsprechenden Eingang I8 des Schrittspeichers verbunden ist. Der zugeordnete Ausgang O8 ist mit einer Sicherheitssignalerzeugungseinrichtung 10 verbunden.

Die Ausgänge der vier in der Empfängereinheit 6 zusammengefaßten Lichtempfänger sind mit den Eingängen A0-A3 des ROM 11 verbunden. Die jeweilige Speicheradresse des ROM 11 umfaßt also eine erste Teiladresse, die durch die Ausgangssignale der Rückführungsausgänge des Schrittspeichers 12 gebildet wird und eine zweite Teiladresse, die aus den Ausgangssignalen der Empfänger der Lichtschranken 2-5 besteht.

Die Funktion der in Fig. 1 dargestellten Einrichtung wird anhand von Fig. 2 erläutert, in der beispielhaft die Zustände der verschiedenen Eingänge und Ausgänge des ROM für die einzelnen Schritte einer mit Hilfe des ROM-Schrittschaltwerkes ablaufenden Schrittfolge dargestellt sind.

Die vier ersten Zeilen der Schrittfolgetabelle zeigen die Zustände im Normalbetrieb, d.h. bei freier Lichtschranke. Der an den Ausgängen Q2,Q3 und Q8 jeweils anliegende Speicherinhalt der durch die Eingangssignale des ROM adressierten Speicherplätze wird bei der Herstellung des Gerätes festgelegt.

Die Schrittfolge und die Ansteuerung der Sender wird durch die an den Rückführungsausgängen Q2,Q3 anliegenden N-Bit-Worte festgelegt, die sich zyklisch wiederholen. Im dargestellten Fall sind es die vier möglichen Zustände eines 2-Bit-Wortes, d.h. die Zahl der angesteuerten Lichtschranken entspricht der maximal möglichen Anzahl verschiedener Zustände an den Rückführungsausgängen. Dies ist jedoch nicht notwendig. Es können auch mehr Rückführungsausgänge vorhanden sein, als zur Ansteuerung der Lichtschranken notwendig sind, wie im folgenden noch näher erläutert.

In jedem Fall ist die Bedingung eines sich zyklisch wiederholenden Bit-Musters aber dahingehend zu verstehen, daß keines der an den Rückführungsausgängen in einer Normalbetriebs-Schrittfolge anstehenden Bit-Muster doppelt vorkommt und daß jeweils das an den Rückführungsausgängen anliegende Bit-Muster diejenige erste Teiladresse des nächstfolgenden Schrittes bildet, die zusammen mit einer zweiten Teiladresse, die einem ungestörten Zustand der jeweils angesteuerten Lichtschranke entspricht, denjenigen Speicherplatz des ROM adressiert, in dem das nächste Bit-Muster des festliegenden Normalbetriebszyklus abgespeichert ist.

In Figur 2 enthält die zweite Teiladresse jeweils für die angesteuerte Lichtschranke eine logische 1 und für die übrigen Lichtschranken eine 0. Die dadurch in Verbindung mit der jeweiligen ersten Teiladresse angesteuerten Speicherplätze enthalten jeweils die erste Teiladresse des nächsten Schrittes. Man erkennt dies in der Figur dadurch, daß die Ausgangssignale der Spalten Q2 und Q3 jeweils mit der nächsten Zeile der Eingangssignale der Spalten A10 und A11(die letzte Ausgangszeile mit der ersten Eingangszeile)übereinstimmen.

Aufgrund dieser Bedingungen durchläuft das ROM-Schrittschaltwerk ständig die in Figur 2 in den ersten vier Zeilen dargestellten Zustände (Schritte), wobei bei jedem Takt des Taktgenerators 13 eine Umschaltung in den nächsten Zustand erfolgt. Über den Decoder 9 werden somit die Sender der Sendeeinheit 1 zyklisch angesteuert. Die zyklische Schleife wird nicht unterbrochen, solange die Lichtschranken frei sind. Bezüglich des Ausganges Q8 enthalten sämtliche vier dabei angesteuerten Speicherstellen des ROM eine logische 1. Diese liegt an der Sicherheitssignalerzeugungseinrichtung 10 an, wobei in dem Fachmann geläufiger Weise beispielsweise ein Relais angezogen werden kann, über das die Maschine, deren Sicherheit überwacht werden soll, mit Strom versorgt wird.

Für jedes vom Normalbetrieb abweichende Bit-Muster an den Eingängen A0 bis A3, A10 und A11 enthält das ROM einen Speicherinhalt, auf den die Sicherheitssignalerzeugungseinrichtung 10, beispielsweise mit Hilfe einer entsprechenden Decoder-Schaltung dahingehend anspricht, daß sie ein Sicherheitssignal abgibt.

Im dargestellten Fall wird die Erzeugung des Sicherheitssignales durch den Nutzsignalausgang Q8 bestimmt. Er enthält für alle Speicherplätze, die nicht den Normalbetriebsadressen entsprechen, eine logische 0. Diese wird von der Sicherheitssignalerzeugungseinrichtung in ein entsprechendes Sicherheitssignal umgewandelt.

Vorzugsweise ist für den Störfall der Speicherinhalt derjenigen Rückführungsausgänge, die für die Ansteuerung der Sender von Bedeutung sind (hier Q2, Q3), identisch mit dem Zustand der Eingänge, auf die sie rückgeführt sind. Dadurch wird nach Taktung des Schrittschaltwerkes wieder der Sender der gleichen Lichtschranke angesteuert. Zweckmäßigerweise wird dabei zugleich die Lichtschranke, die für die Störung "verantwortlich" war, angezeigt. Dies kann beispielsweise durch eine parallel zum Lichtsender geschaltete Leuchtdiode 18 geschehen.

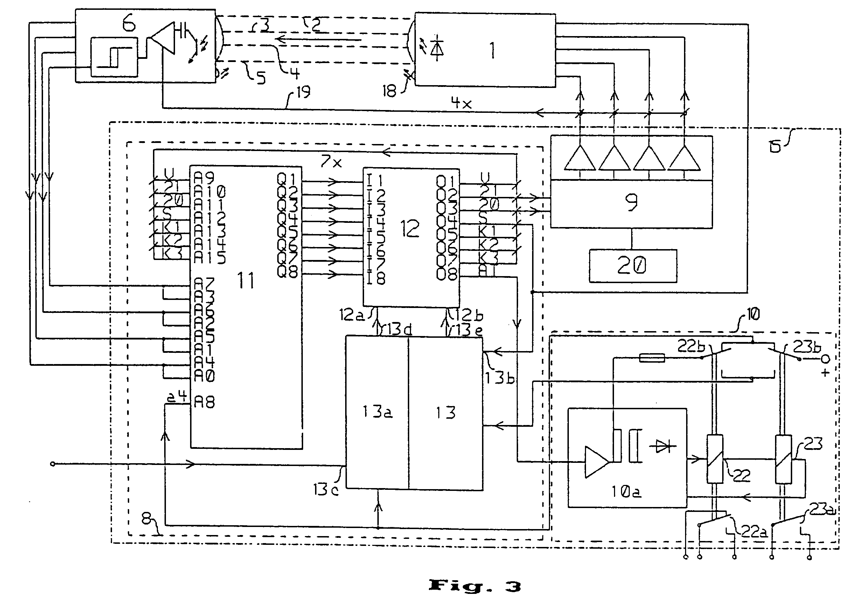

In Figur 3 ist ein Ausführungsbeispiel dargestellt, das unter weitgehender Ausnutzung der Möglichkeiten kostengünstig erhältlicher kommerzieller Bausteine mehrere zusätzliche Sicherheitsfunktionen realisiert und dadurch mit verhältnismäßig einfachen Mitteln ein außerordentlich hohes Maß an Sicherheit durch ständige Überwachung der Funktionen garantiert.

Entsprechende Bauteile sind mit den gleichen Ziffern wie in Figur 1 bezeichnet und werden hier nicht nochmals beschrieben. Zusätzlich sind folgende Elemente dargestellt.

Der Taktgenerator 13 weist eine Freigabeschaltung 13a auf, die von einer am Eingang 13c anliegenden nicht dargestellten Folgesteuerung betätigt wird, wenn die Maschine in Betrieb gesetzt wird. Der Ausgang 13d der Freigabeeinheit liegt an einem Eingang 12a des Schrittspeichers an. Der Takt des Taktgenerators 13 (Ausgang 13e) wird am Eingang 12b zugeführt.

Dem Decoder 9 ist ein Sendetaktgenerator 20 vorgeschaltet, der die Sender mit einer im Vergleich zur Schrittfolgefrequenz des PROM-Schrittschaltwerkes 8 hohen Frequenz taktet. Typischerweise kann der Sendetaktgenerator 20 einen Sendetakt von 8 KHz erzeugen, während die Arbeitsfrequenz des PROM-Schrittschaltwerkes z.B. 750 Hz beträgt, so daß vier Lichtschranken in ca. 5 msec. abgefragt werden. Die Taktung der Lichtsender ist in der einschlägigen Technik üblich, um Fremdlichtstörungen zu vermindern. Das Sendertaktsignal wird über die Leitung 19 parallel als Auftastsignal an den jeweiligen Empfänger angelegt.

Ebenfalls in Figur 3 dargestellt sind die Ausgangsrelais 22 und 23 mit den Ausgangskontakten 22a und 23a. Diese aktivieren über eine Nachfolgesteuerung den Antriebsmotor . Zusätzlich sind Hilfskontakte 22b, 23b vorgesehen, die als Wechselkontakte ausgebildet sind und deren Funktion weiter unten erläutert wird.

Als ROM wird im dargestellten Fall ein 64K x8 EPROM mit sechzehn Eingängen und acht Ausgängen eingesetzt. Als Schrittspeicher -Baustein 12 dient ein 8x D-Flipp-Flopp. Die gegenüber der einfachen Version nach Fig. 1 und 3 zusätzlich vorhandenen Ein- und Ausgänge werden zur Realisierung der im folgenden beschriebenen Sicherheitsfunktionen genutzt.

Von den acht Ausgängen des ROM 11 sind sieben, nämlich die Ausgänge Q1 - Q7 Rückführungsausgänge. Ihre Bit-Muster liegen also jeweils beim Folgeschritt an den entsprechenden Eingängen, nämlich den Eingängen A9 - A15 des ROM an. Der einzige zusätzliche Ausgang des ROM ist der Nutzsignalausgang Q8. Der entsprechende Ausgang 08 des Zwischenspeichers ist mit der Sicherheitssignalerzeugungseinrichtung 10 verbunden. Gewünschtenfalls kann auch der Nutzsignalausgang zurückgeführt sein, wobei dann alle Ausgänge Rückführungsausgänge sind.

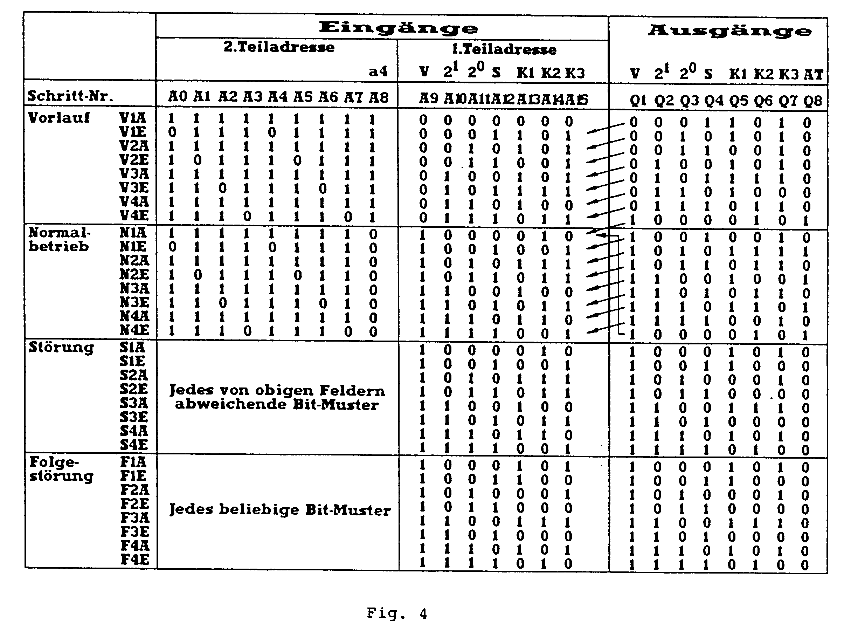

Die Grundfunktion ist ähnlich wie bei der zuvor beschriebenen Ausführungsform. In der Spalte Ausgänge von Figur 4 ist der Speicherinhalt dargestellt, der in den Speicherplätzen des ROM abgespeichert ist, die durch die jeweils in der gleichen Zeile dargestellten Adresseneingänge angesteuert sind. Die an den Eingängen A9-A15 anliegende erste Teiladresse ist aufgrund der Rückführung identisch mit dem Bit-Muster, das beim vorhergehenden Schritt an den Ausgängen Q1 - Q7 anlag.

Eine zweite Teiladresse wird durch die Empfängersignale gebildet, die in diesem Fall mit jeweils zwei Eingängen des ROM parallel verbunden sind. Dies führt zu einer Erhöhung der Übertragungssicherheit, jedoch kann es auch zweckmäßig sein, auf die Parallelführung der Empfängersignale zu verzichten, insbesondere wenn mehr als vier Lichtschranken eingesetzt und dennoch kein größerer ROM-Baustein verwendet werden soll.

Dadurch, daß auch die Empfänger der nicht aktivierten Lichtschranken bei jedem Schritt abgefragt werden, werden verschiedene mögliche Fehlfunktionen, zum Beispiel Kurzschlüsse zwischen den Sendern, erkannt. In einer vereinfachten Version können die Empfänger auch über einen Datenselektor an einen einzigen Anschluß des ROM angeschlossen sein.

Die Speicherinhalte der durch die Gesamtadresse adressierten Speicherplätze bilden wiederum eine vorbestimmte zyklische Folge in dem weiter oben definierten Sinn.

Von den Rückführungssignalen dienen die mit 2¹ und 2⁰ bezeichneten Signale an den Ausgängen Q2 und Q3 zur Ansteuerung der Lichtsender 1 über den Decoder 9. Das Schrittfolgediagramm zeigt, daß sich die Bit-Muster an diesen Ausgängen jeweils in zwei aufeinanderfolgenden Schritten wiederholen, d.h.jede Lichtschranke wird in zwei aufeinanderfolgenden Schritten des Schrittschaltwerkes angesteuert.

Von diesen jeweils zwei Schritten befindet sich der Lichtsender jedoch nur in jeweils einem Schritt in Betrieb, nämlich dann, wenn das an dem Senderaktivierungsausgang Q4 anliegende Signal S eine logische 1 hat. In der ersten Spalte sind die entsprechenden Schritte bezeichnet, wobei N für Normalbetrieb steht und die Ziffer jeweils die Nummer der Lichtschranke bezeichnet. A bedeutet, daß die Lichtschranke ausgeschaltet und E daß sie eingeschaltet ist.

Mit Hilfe des Signals S können Fehlfunktionen in den aufgetasteten Empfängern der Lichtschranken erkannt werden. Aufgrund der Auftastung kann es nämlich vorkommen, daß sich das Empfängersignal infolge einer elektronischen Fehlfunktion synchron zum Sendersignal verhält, obwohl in Wahrheit die Lichtschranke unterbrochen ist. Die Schritte, bei denen der entsprechende Sender zwar angesteuert, jedoch nicht eingeschaltet ist, erlauben die Erkennung solcher Fehler.

Wie aus Figur 4 zu ersehen ist, wird im Normalbetrieb am Nutzsignalausgang Q8 jeweils ein 0-Signal erzeugt, wenn das am Sendeaktivierungsausgang anstehende Signal eine 1 ist und umgekehrt. Es resultiert ein in der Taktfrequenz des Taktgenerators 13 alternierendes Signal am Ausgang Q8. Vorteilhafterweise enthält in einem solchen Fall, die Sicherheitssignalerzeugungseinrichtung 10 einen selektiven Ausgangsübertrager 10a, der auf diese Frequenz selektiv anspricht. Dadurch werden Störeinflüsse durch andere Frequenzen reduziert.

Bevorzugt erzeugt der Taktgenerator 13 Takte mit stark unsymmetrischem Taktverhältnis (mindestens 2:1). Entsprechend asymmetrisch ist dann das Signal am Nutzsignalausgang O8.

Eine weitere Sicherheitsfunktion wird durch die Signale K1, K2 und K3 ermöglicht, die an den Kontrollausgängen Q5, Q6 und Q7 anliegen. Sie sind so gewählt, daß sämtliche Bit-Muster an den Rückführungsausgängen Q1 - Q7 sich untereinander an mindestens zwei Stellen unterscheiden. Ohne diese Maßnahme wäre es beispielsweise möglich, daß bei einem Bitverlust an einem der Ausgänge eine unerwünschte Schleife gebildet würde, weil statt der nächstfolgenden Lichtschranke eine andere Lichtschranke angesteuert würde. Dies könnte zum Beispiel dazu führen, daß eine der Lichtschranken aus der Schrittfolge des Schrittschaltwerks herausfällt. Dies wird durch die Signalfolgen K1 und K3 zuverlässig verhindert, weil ein Bitverlust praktisch nicht gleichzeitig an zwei verschiedenen Stellen eintreten kann.

Ein weiterer Rückführungsausgang Q1 des ROM 11 dient dazu, einen Vorlauf (Schrittbezeichnung beginnend mit V) zu ermöglichen, bei dem das Ausgangsrelais noch nicht angesteuert wird. Wie aus Figur 4 zu ersehen ist, unterscheiden sich die Speicherinhalte während des Vorlaufes nur in den Ausgängen Q1 und Q8, die während der ersten sieben Schritte des Vorlaufs eine logische 0 enthalten und im achten Schritt auf Logisch 1 springen.

Die Funktion dieser Maßnahme läßt sich am besten im Zusammenhang mit dem Anlaufvorgang erläutern. In den Schritt V1A gelangt man durch Reset. Dabei werden durch ein von der Freigabeeinheit 13a an den Eingang 12a des Speichers 12 angelegtes Signal , dessen Speicherstellen auf 0 gesetzt, so daß ein entsprechendes Bit-Muster auch an den Rückführungseingängen A9 - A 15 des ROM anliegt. Da keiner der Empfänger ein Signal erzeugt liegt an den Eingängen A0-A8 jeweils eine logische 1.

Der durch die Gesamtadresse adressierte Speicherplatz des ROM hat den in der ersten Zeile von Figur 4 dargestellten Inhalt an den Ausgängen Q1-Q8. Nach dem ersten Takt des Schrittspeichers (Schritt V1E) bildet dieser Speicherinhalt die erste Teiladresse an den Eingängen A9-A15. Aufgrund des am Ausgang 04 des Schrittspeichers anstehenden Signals S=1 wird der Sender der ersten Lichtschranke eingeschaltet. Bei freier Lichtschranke liegt an den Eingängen A0 und A4 eine logische 0 an. Der Speicherinhalt der somit definierten Gesamtadresse ist in der mit V1E bezeichneten Zeile dargestellt. Entsprechend laufen die weiteren Schritte ab, wie dies in Fig. 4 dargestellt ist.

Dadurch, daß im Vorlauf jeweils eine logische 0 am Eingang A9 anliegt, werden Speicherplätze angesteuert, die am Nutzsignalausgang Q8 jeweils eine logische 0 haben. Da sich die Rückführungseingänge im übrigen im Vorlauf nicht vom Normalbetrieb unterscheiden, werden nacheinander sämtliche Lichtschranken angesteuert und die Funktionen der Sicherheitseinrichtung überprüft, während gleichzeitig die am Nutzsignalausgang Q8 statisch anstehende logische 0 dafür sorgt, daß die Relais 22,23 noch nicht anziehen können.

Dadurch wird eine Überprüfung der Funktionen der Sicherheitseinrichtung vor Anlaufen der überwachten Maschine ermöglicht. Wäre der Vorlauf nicht vorgesehen, so bestünde, insbesondere bei einer großen Zahl von Lichtschranken, ein Risiko, daß die Maschine schon anläuft, weil die ersten überprüften Lichtschranken frei sind, obwohl eine weitere, kurz darauf abgefragte Lichtschranke unterbrochen ist. Durch den Vorlauf wird dieses Sicherheitsrisiko unterbunden.

Ist der Vorlauf ohne Fehler absolviert, so tritt das Schrittschaltwerk in den Normalbetrieb über, in dem in der oben beschriebenen Weise die Lichtschranken zyklisch eingeschaltet und abgefragt werden.

Die Schritte S1A bis S4E (S für Störung) geben die Bit-Kombinationen an, die bei einer "fehlerhaften" Abfrage entstehen. Eine Störung drückt sich dadurch aus, daß an einem der Eingänge A0 bis A7 eine Abweichung von dem Bit-Muster des Vorlaufs bzw. Normalbetriebs eintritt. Dabei steht an den Eingängen A9 bis A15 normalerweise, wie in Fig. 4 dargestellt, die aus der Rückführung resultierende erste Teiladresse an. Der für diesen Fall vorgesehenen Speicherinhalt des ROM ist in der Ausgangsspalte des mit Störung bezeichneten Blocks dargestellt. Der Ausgang Q8 ist in jedem Falle gleich 0. Dadurch erhält der selektive Ausgangsübertrager 10a kein Eingangssignal mehr. Die Versorgungsspannung für die Erregerspulen der Relais 22 und 23 wird unterbrochen und die Ausgangskontakte 22a, 23a öffnen sich.

Bevorzugt ist dabei, ebenso wie bei der Ausführungsform nach Figuren 1 und 2, der Speicherinhalt an den Ausgängen Q2, Q3 und Q4, also bezüglich der für die Ansteuerung der Sender verantwortlichen Signale, identisch mit den entsprechenden Adresseeingängen A10 bis A12, auf die die Ausgänge rückgeführt sind.

Bei der in Figur 3 dargestellten Ausführungsform ist der Ausgang O4 des Schrittspeichers 12 nicht nur mit der Sendeeinheit 1, sondern auch mit dem Eingang 13b des Taktgenerators 13 verbunden. Das am Ausgang O4 anliegende Signal S wechselt, wie aus Figur 4 zu ersehen ist, bei jedem Schritt des Normalbetriebszyklus seinen digitalen Zustand von 0 auf 1 bzw. von 1 auf 0. Im Störfall dagegen behält es den Zustand, den es im vorhergehenden Schritt hatte. Der Taktgenerator ist dabei so geschaltet, daß er nur so lange Takte an seinem Ausgang 13e erzeugt, wie an seinem Eingang 13b ein wechselnder Takt anliegt. Dadurch wird erreicht, daß der Taktgenerator 13 und demzufolge das Schrittschaltwerk 8 im Störfall stehenbleibt. Dadurch wird der Sicherheitsgrad zusätzlich erhöht.

Um im Störungszustand einen noch höheren Sicherheitsstandard zu gewährleisten, ist die in Fig. 4 mit Folgestörung bezeichnete Funktion vorgesehen. Sie enthält für alle Adressen, bei denen die erste Teiladresse dem Störungszustand entspricht, am Ausgang wiederum den Speicherinhalt des Störungszustandes, so daß beim nächsten Takt ein Rücksprung in den Störungszustand erfolgt.

Der Eingang A8 des PROM ist zur Überprüfung der Relaisfunktion vorgesehen. Aufgrund der in Figur 3 dargestellten Beschaltung der Hilfskontakte 22b, 23b liegt an A8 eine logische 1 an, solange in der Vorlaufphase die Relais noch nicht anziehen. Im Normalbetrieb springt das Signal mit Anziehen der Relais auf Logisch 0. Da das Signal A4 am Ausgang A8 gemeinsam mit den übrigen Eingangssignalen die Adressierung bestimmt, führt jede Abweichung von diesem Betriebsmuster, wie sie für eine Störung an den Relais typisch wäre, ebenfalls zu einem Fehlersignal und damit zur Abschaltung der Maschine.

Wie aus Figur 4 zu ersehen ist, sind die Sequenzen aller Eingänge des ROM 11 mit Ausnahme der parallel geschalteten Eingänge für die Empfängersignale verschieden. Dadurch führt ein Kurzschluß zwischen den Eingangsleitungen zu einem Störungssignal.

## Patentansprüche

1. Lichtschranken-Sicherheitseinrichtung mit
1 mehreren Lichtschranken (2-5), die jeweils einen Lichtsender und einen Lichtempfanger aufweisen, und
2 einer Zentraleinheit (15), an der die Signale der Lichtschranken (2-5) anliegen, wobei
2.1 die Zentraleinheit (15) ein Schrittschaltwerk mit Schrittspeicher (12) und einen Taktgenerator (13) enthält, und
2.2 die Zentraleinheit (15) ein Sicherheitssignal erzeugt, wenn mindestens eine Lichtschranke unterbrochen wird,
**gekennzeichnet durch** folgende Merkmale:
3 Das Schrittschaltwerk ist als ROM-Schrittschaltwerk (8) ausgebildet, welches ein ROM (11), den Schrittspeicher (12), welcher dem ROM (11) nachgeordnet ist und mindestens N bistabile Speicherstellen aufweist, und den Taktgenerator (13), welcher zur Taktung des Schrittspeichers (12) dient, enthält,
3.1 wobei mindestens ein Teil N der Ausgänge des ROM (11) als Rückführungsausgange (Q1-Q7) an N Rückführungseingängen (I1-I7) des Schrittspeichers (12) anliegt und
3.2 die entsprechenden N Ruckfuhrungsausgange (01-07) des Schrittspeichers (12) auf Rückführungseingänge (A9-A15) des ROM (11) zuruckgeführt sind,
3.3 so daß das jeweils an den Rückführungsausgängen (01-07) des Schrittspeichers (12) anliegende N-Bit-Wort einen Teil der am Eingang des ROM (11) anliegenden Adresse (erste Teiladresse) ist und das jeweils an den Rückführungsausgängen (Q1-Q7) des ROM (11) anliegende N-Bit-Wort nach Taktung des Schrittspeichers (12) die nächstfolgende erste Teiladresse bildet und infolgedessen eine durch den Speicherinhalt des ROM (11) vorbestimmte Schrittfolge abläuft, solange der Schrittspeicher (12) Taktsignale von dem Taktgenerator (13) erhält;
4 mindestens ein Teil M der Ausgänge des ROM (11) wird als Ansteuerungsausgänge (Q2,Q3) verwendet, um Signale zum Ansteuern der Lichtsender zu erzeugen;
5 ein Teil der Eingänge des ROM (11) dient als Empfängereingänge (A0-A7), an die die Empfängersignale anliegen, so daß sie eine zweite Teiladersse des ROM (11) bilden;
6 die durch die Gesamtadresse aus erster Teiladresse und zweiter Teiladresse bestimmten Speicherstellen des ROM (11) enthalten
6.1 für den Fall, daß die zweite Teiladresse einer funktionierenden ununterbrochenen Lichtschranke entspricht (Normalbetriebsfall), eine vorbestimmte Folge von Bit-Mustern, bei der sich die an den Rückführungsausgängen anliegenden N-Bit-Worte zyklisch wiederholen, so daß sich die Schrittfolge des ROM-Schrittschaltwerkes (8) ebenfalls zyklisch wiederholt und die Lichtschranken über die Ansteuerungsausgänge zyklisch angesteuert werden,
6.2 für den Fall, daß die zweite Teiladresse nicht einer ununterbrochenen Lichtschranke entspricht, (Störfall) einen von der vorbestimmten Folge von Bit-Mustern abweichenden Speicherinhalt;
7 mindestens einer der Ausgange des Schrittspeichers (12) dient als Nutzsignalausgang (08), der mit einer Sicherheitssignalerzeugungseinrichtung (10) verbunden ist, die aufgrund des im Storfall abweichenden Speicherinhaltes das Sicherheitssignal erzeugt.

2. Lichtschranken-Sicherheitseinrichtung nach Anspruch 1, **dadurch gekennzeichnet,** daß N größer als die zur Codierung der Lichtschranken (2-5) mindestens notwendige Bitzahl ist.

3. Lichtschranken-Sicherheitseinrichtung nach einem der vorhergehenden Ansprüche, **dadurch gekennzeichnet,** daß die im Störfall adressierten Speicherstellen des ROM (11) an denjenigen Rückführungsausgängen (Q2,Q3,Q4), die für die Ansteuerung der Sender von Einfluß sind, das gleiche Bit-Muster enthalten wie die Adresseneingänge (A10,A11,A12), auf die sie rückgeführt sind.

4. Lichtschranken-Sicherheitseinrichtung nach einem der Ansprüche 2 oder 3, **dadurch gekennzeichnet,** daß das ROM (11) zusätzliche Kontrollausgange (Q5-Q7), die ein Teil der Rückführungsausgänge sind, aufweist und der Speicherinhalt des ROM (11) bezüglich der Kontrollausgänge so gewählt ist, daß sich alle N-Bit-Worte an den Rückführungsausgängen jeweils in mindestens zwei Bit voneinander unterscheiden.

5. Lichtschranken-Sicherheitseinrichtung nach einem der Ansprüche 2-4, **dadurch gekennzeichnet,** daß das ROM (11) einen zusätzlichen Vorlaufausgang (Q1) aufweist, der zu den Rückführungsausgängen gehört und einen Vorlauf zur Überprüfung der Funktionen der Sicherheitseinrichtung codiert.

6. Lichtschranken-Sicherheitseinrichtung nach einem der Ansprüche 2-5, **dadurch gekennzeichnet,** daß zur Verstärkung der Empfängersignale ein Schaltverstärker mit Sendeimpulsauftastung vorgesehen ist und das ROM (11) einen Sendeaktivierungsausgang (Q4) aufweist, der zur Funktionskontrolle des Schaltverstärkers dient.

7. Lichtschranken-Sicherheitseinrichtung nach einem der Ansprüche 2-6, **dadurch gekennzeichnet,** daß der Speicherinhalt des ROM (11) bezüglich eines Rückführungsausganges (Q4) so gewählt ist, daß er bei jedem Schritt des Normalbetriebszyklus seinen digitalen Zustand ändert und bei jedem Storfall im digitalen Zustand des vorhergehenden Schritts bleibt und dieser Rückführungsausgang an einen Triggereingang (13b) des Taktgenerators (13) anliegt, wobei der Taktgenerator so ausgebildet ist, daß er nur bei alternierenden Signalen an dem Triggereingang (13b) einen Takt erzeugt.

8. Lichtschranken-Sicherheitseinrichtung nach einem der vorhergehenden Ansprüche, **dadurch gekennzeichnet,** daß die Sicherheitssignalerzeugungseinrichtung (10) zwei Sicherheitsrelais (22,23) steuert und ein Hilfskontakt (23b) der Sicherheitsrelais mit einem Relaisprufungseingang (A8) des ROM (11) verbunden ist.

9. Lichtschranken-Sicherheitseinrichtung nach einem der vorhergehenden Ansprüche, **dadurch gekennzeichnet,** daß die Sicherheitssignalerzeugungseinrichtung (10) einen Ausgangsübertrager (10a) einschließt, der für eine von dem ROM-Schrittschaltwerk (8) im Normalbetrieb an dem Nutzsignalausgang (08) erzeugte Impulsfrequenz selektiv ist.

10. Lichtschranken-Sicherheitseinrichtung nach Anspruch 9, **dadurch gekennzeichnet,** daß der Taktgenerator (13) so ausgebildet ist, daß er Takte mit einem asymmetrischen Taktverhaltnis erzeugt, so daß auch die von dem ROM-Schrittschaltwerk (8) erzeugte Impulsfrequenz asymmetrisch ist.

## Claims

1. Light-barrier safety device comprising
1 a plurality of light barriers (2-5) which each comprise a light emitter and a light receiver, and
2 a central unit (15) to which the signals of the light barriers (2-5) are applied,
2.1 the central unit (15) containing a stepping switch with step memory (12) and clock generator (13), and
2.2 the central unit (15) generating a safety signal if at least one light barrier is interrupted,
**characterized by the following features:**
3 the stepping switch is designed as an ROM stepping switch (8) which contains an ROM (11), the step memory (12), which is arranged downstream of the ROM (11) and has at least N bistable memory locations, and the clock generator (13), which serves to clock the step memory (12),
3.1 at least a portion N of the outputs of the ROM (11) being applied as feedback outputs (Q1-Q7) to N feedback inputs (I1-I7) of the step memory (12), and
3.2 the corresponding N feedback outputs (O1-O7) of the step memory (12) being fed back to the feedback inputs (A9-A15) of the ROM (11)
3.3 so that the N-bit word applied in each case to the feedback outputs (O1-O7) of the step memory (12) is a portion of the address (first subaddress) applied to the input of the ROM (11) and the N-bit word applied in each case to the feedback outputs (Q1-Q7) of the ROM (11) forms the subsequent first subaddress after clocking of the step memory (12) and, consequently, a step sequence predetermined by the memory content of the ROM (11) takes place for as long as the step memory (12) receives clock signals from the clock generator (13);
4 at least a portion M of the outputs of the ROM (11) is used as drive outputs (Q2, Q3) to generate signals for driving the light emitters;
5 a portion of the inputs of the ROM (11) serves as receiver inputs (A0-A7) to which the receiver signals are applied so that they form a second subaddress of the ROM (11);
6 the memory locations of the ROM (11) which are determined by the total address comprising first subaddress and second subaddress contain,
6.1 for the case where the second subaddress corresponds to a functioning uninterrupted light barrier (normal operating case), a predetermined sequence of bit patterns in which the N-bit words applied to the feedback outputs repeat cyclically so that the step sequence of the ROM stepping switch (8) also repeats cyclically and the light barriers are driven cyclically via the drive outputs,
6.2 for the case where the second subaddress does not correspond to an uninterrupted light barrier (fault case), a memory content which deviates from the predetermined sequence of bit patterns;
7 at least one of the outputs of the step memory (12) serves as useful signal output (O8) which is connected to a safety signal generating device (10) which generates the safety signal on the basis of a deviant memory content in the fault case.

2. Light-barrier safety device according to Claim 1, **characterized in** that N is greater than the bit number at least necessary to code the light barriers (2-5).

3. Light-barrier safety device according to one of the preceding claims, **characterized in** that the memory locations of the ROM (11) which are addressed in the fault case contain, at those feedback outputs (Q2, Q3, Q4) which influence the drive of the emitters, the same bit pattern as the address inputs (A10, A11, A12) to which they are fed back.

4. Light-barrier safety device according to either of Claims 2 or 3, **characterized in** that the ROM (11) has control outputs (Q5-Q7) which form a portion of the feedback outputs, and the memory content of the ROM (11) in relation to the control outputs is chosen in such a way that all the N-bit words at the feedback outputs always differ from one another in at least two bits.

5. Light-barrier safety device according to one of Claims 2-4, **characterized in** that the ROM (11) has an additional, initial-run output (Q1) which belongs to the feedback outputs and codes an initial run for checking the functions of the safety device.

6. Light-barrier safety device according to one of Claims 2-5, **characterized in** that, to amplify the receiver signals, a switching amplifier with emission pulse gating is provided and the ROM (11) has an emission activation output (Q4) which serves to check the functioning of the switching amplifier.

7. Light-barrier safety device according to one of Claims 2-6, **characterized in** that the memory content of the ROM (11) relating to a feedback output (Q4) is chosen in such a way that it changes its digital state for each step in the normal operation cycle and, in the event of any fault, remains in the digital state of the preceding step, and said feedback output is applied to a trigger input (13b) of the clock generator (13), the clock generator being designed in such a way that it generates a clock pulse only if there are alternating signals at the trigger input (13b).

8. Light-barrier safety device according to one of the preceding claims, **characterized in** that the safety signal generating device (10) controls two safety relays (22, 23) and an auxiliary contact (23b) of the safety relay is connected to a relay test input (A8) of the ROM (11).

9. Light-barrier safety device according to one of the preceding claims, **characterized in** that the safety signal generating device (10) includes an output transformer (10a) which is selective for a pulse frequency generated by the ROM stepping switch (8) at the useful signal output (O8) in normal operation.

10. Light-barrier safety device according to Claim 9, **characterized in** that the clock generator (13) is designed in such a way that it generates clock pulses having an asymmetrical clock ratio so that the pulse frequency generated by the ROM stepping switch (8) is also asymmetrical.

## Revendications

1. Dispositif de sécurité à barrière photoélectrique, comprenant
1 plusieurs barrières photoélectriques (2 à 5) avec chacune un émetteur de lumière et un récepteur de lumière, et
2 une unité centrale (15) à laquelle sont transmis les signaux desdites barrières photoélectriques (2 à 5),
2.1 l'unité centrale (15) étant équipée d'un mécanisme pas à pas avec mémoire de pas (12) et d'un rythmeur (13), et
2.2 l'unité centrale (15) générant un signal de sécurité lorsqu'au moins une barrière photoélectrique est interrompue,
**caractérisé** par les particularités suivantes :
3 Le mécanisme pas à pas est conformé en mécanisme pas à pas ROM (8) qui comprend une ROM (11), la mémoire de pas (12) montée en aval de la ROM (11) et présentant au moins N emplacements de mémoire bistables, et le rythmeur (13) qui sert à la synchronisation de la mémoire de pas (12),
3.1 au moins une partie N des sorties de la ROM (11) étant reliées, comme sorties de réinjection (Q1 à Q7), à N entrées de réinjection (I1 à I7) de la mémoire de pas (12), et
3.2 les N sorties de réinjection (O1 à O7) correspondantes de la mémoire de pas (12) étant ramenées à des entrées de réinjection (A9 à A15) de la ROM (11)
3.3 de telle façon que le mot de N bits qui apparaît respectivement aux sorties de réinjection (O1 à O7) de la mémoire de pas (12) forme une partie de l'adresse transmise à l'entrée de la ROM (11) (première adresse partielle) et que le mot de N bits qui, après la synchronisation de la mémoire de pas (12), apparaît respectivement aux sorties de réinjection (Q1 à Q7) de la ROM (11) forme la première adresse partielle suivante, ce qui a pour effet le déroulement d'une séquence de pas prédéterminée par le contenu de mémoire de la ROM (11) aussi longtemps que la mémoire de pas (12) reçoit des signaux de commande délivrés par le rythmeur (13);
4 au moins une partie des M sorties de la ROM (11) est utilisée comme sorties de commande (Q2, Q3) pour la génération de signaux pour l'activation des émetteurs de lumière;
5 une partie des entrées de la ROM (11) sert d'entrées de réception (A0 à A7) auxquelles sont transmis les signaux de réception, de façon à former une seconde adresse partielle de la ROM (11);
6 les emplacements de mémoire de la ROM (11) définis par l'adresse globale constituée par la première adresse partielle et la seconde adresse partielle, contiennent
6.1 au cas où la seconde adresse partielle correspond à une barrière photoélectrique en fonctionnement et non interrompue (état de service normal), une séquence prédéterminée de configurations binaires pour laquelle les mots de N bits apparaissant aux sorties de réinjection se répètent de manière cyclique de façon que la séquence de pas du mécanisme pas à pas ROM (8) se répète également de manière cyclique et que les barrières photoélectriques sont activées de manière cyclique par l'intermédiaire des sorties de commande,
6.2 au cas où la seconde adresse partielle ne correspond pas à une barrière photoélectrique non interrompue (incident), un contenu de mémoire qui diffère de la séquence prédéterminée de configurations binaires;
7 au moins l'une des sorties de la mémoire de pas (12) sert de sortie de signal utile (O8) qui est reliée à un générateur de signaux de sécurité (10) qui, en raison de la différence du contenu de mémoire en cas d'incident, génère le signal de sécurité.

2. Dispositif de sécurité à barrière photoélectrique selon la revendication 1, caractérisé en ce que N est plus grand que le nombre de bits minimum nécessaire au codage des barrières photoélectriques (2 à 5).

3. Dispositif de sécurité à barrière photoélectrique selon l'une des revendications précédentes, caractérisé en ce que les emplacements de mémoire de la ROM (11) adressés en cas d'incident contiennent aux sorties de réinjection (Q2, Q3, Q4) agissant sur la commande des émetteurs, la même configuration binaire que les entrées d'adresse (A10, A11, A12) auxquelles elles sont ramenées.

4. Dispositif de sécurité à barrière photoélectrique selon l'une des revendications 2 ou 3, caractérisé en ce que la ROM (11) comporte des sorties de contrôle (Q5 à Q7) supplémentaires lesquelles font partie des sorties de réinjection, et que le contenu de mémoire de la ROM (11) est choisi, en ce qui concerne les sorties de contrôle, de telle façon que tous les mots de N bits apparaissant aux sorties de réinjection diffèrent les uns des autres d'au moins deux bits.

5. Dispositif de sécurité à barrière photoélectrique selon l'une des revendications 2 à 4, caractérisé en ce que la ROM (11) comporte une sortie d'avance (Q1) supplémentaire qui fait partie des sorties de réinjection et assure le codage d'une avance pour la vérification des fonctions du dispositif de sécurité.

6. Dispositif de sécurité à barrière photoélectrique selon l'une des revendications 2 à 5, caractérisé en ce qu'il comprend pour l'amplification des signaux de réception, un amplificateur de commutation avec déclenchement d'une impulsion d'émission, et que la ROM (11) comporte une sortie d'activation d'émission (Q4) qui sert au contrôle fonctionnel de l'amplificateur de commutation.

7. Dispositif de sécurité à barrière photoélectrique selon l'une des revendications 2 à 6, caractérisé en ce que, en ce qui concerne une sortie de réinjection (Q4), le contenu de mémoire de la ROM (11) est choisi de telle façon qu'il change d'état numérique à chaque pas du cycle de fonctionnement normal et qu'il reste à l'état numérique du pas précédent à chaque incident, et que cette sortie de réinjection est reliée à une entrée de déclencheur (13b) du rythmeur (13), ledit rythmeur étant réalisé de telle façon qu'il ne délivre une impulsion de synchronisation que lorsque des signaux alternatifs sont transmis à l'entrée de déclencheur (13b).

8. Dispositif de sécurité à barrière photoélectrique selon l'une des revendications précédentes, caractérisé en ce que le générateur de signaux de sécurité (10) commande deux relais de sécurité (22, 23), et qu'un contact auxiliaire (23b) des relais de sécurité est relié à une entrée de vérification des relais (A8) de la ROM (11).

9. Dispositif de sécurité à barrière photoélectrique selon l'une des revendications précédentes, caractérisé en ce que le générateur de signaux de sécurité (10) comprend un transmetteur de sortie (10a) qui répond de manière sélective à une fréquence d'impulsions générée par le mécanisme pas à pas ROM (8) en service normal à la sortie de signal utile (O8).

10. Dispositif de sécurité à barrière photoélectrique selon la revendication 9, caractérisé en ce que le rythmeur (13) est conformé de façon à générer des impulsions de synchronisation avec un rapport de synchronisation asymétrique, de sorte que la fréquence d'impulsions générée par le mécanisme pas à pas ROM (8) est, elle aussi, asymétrique.
